# NEUE EUROPÄISCHE PATENTSCHRIFT

(11) **EP 1 620 881 B2**
(45) Veröffentlichungstag und Bekanntmachung des Hinweises auf die Entscheidung über den Einspruch: **20.06.2018**
(45) Hinweis auf die Patenterteilung: 08.10.2008
(21) Anmeldenummer: 04728758.6
(22) Anmeldetag: 22.04.2004
(51) Int. Cl.: H01L 21/306

(54) **VERFAHREN ZUM TEXTURIEREN VON OBERFLÄCHEN VON SILIZIUM-SCHEIBEN**
METHOD FOR TEXTURING SURFACES OF SILICON WAFERS
PROCEDE POUR TEXTURER DES SURFACES DE TRANCHES DE SILICIUM

(30) Priorität: 07.05.2003 DE 10320212
(43) Veröffentlichungstag der Anmeldung: 01.02.2006
(60) Teilanmeldung: 08016611.9
(73) Patentinhaber: Universität Konstanz, 78464 Konstanz (DE)
(72) Erfinder: HAUSER, Alexander, 72351 Geislingen (DE); MELNYK, Ihor, Lwiw 79053 (UA); FATH, Peter, 78464 Konstanz (DE)
(74) Vertreter: Müller-Boré & Partner Patentanwälte PartG mbB
(86) Internationale Anmeldenummer: PCT/DE2004/000835
(87) Internationale Veröffentlichungsnummer: WO 2004/100244

(56) Entgegenhaltungen:
- DE-A- 19 962 136
- DE-A1- 19 962 136
- US-B1- 6 309 467
- PATENT ABSTRACTS OF JAPAN Bd. 0180, Nr. 77 (E-1504), 8. Februar 1994 (1994-02-08) & JP 5 291215 A (MITSUBISHI MATERIALS CORP; others: 01), 5. November 1993 (1993-11-05)
- SCHWARTZ B.ET AL: 'Chemical Etching of Silicon' JOURNAL OF THE ELEKTROCHEMICAL SOCIETY Bd. 108, Nr. 4, April 1961, Seiten 365 - 372
- SCHWARTZ B. ET AL: 'Chemical Etching of Silicon' JOURNAL OF THE ELEKTROCHEMICAL SOCIETY Bd. 123, Nr. 12, Dezember 1976, Seiten 1903 - 1909

## Beschreibung

Die Erfindung betrifft ein Verfahren zum Texturieren zur reflexionsmindernden Strukturierung von Oberflächen von Silizium-Scheiben mit den Schritten des Eintauchens der Silizium-Scheiben in einer Ätzlösung aus Wasser, konzentrierter Flusssäure und konzentrierter Salpetersäure und des Einstellens einer Temperatur für die Ätzlösung.

Ein derartiges Verfahren ist aus dem Artikel "Isotropic Texturing of Multicrystalline Silicon Wafers with Acidic Texturing Solutions" von R. Einhaus, E. Vazsonyi, J. Szlufcik et al., erschienen in dem Tagungsband 26th PVSC, 30. September bis 3. Oktober 1997, Anaheim, Kalifornien, U.S.A., bekannt. Bei dem vorbekannten Verfahren werden multikristalline Silizium-Scheiben in einer temperaturkontrollierten sauren Ätzlösung bestehend aus Wasser, Flusssäure mit einer Konzentration von 50% und Salpetersäure mit einer Konzentration von 70% an der Oberfläche texturiert, um den Wirkungsgrad beeinträchtigende Reflexionen zu verringern.

Aus den Dokumenten US-A-3,309,760, US 2002/0187583 A1, US-A-5,681,398 und US-A-5,174,855 sind Verfahren zum Behandeln von Oberflächen von Silizium-Scheiben bekannt, die dem Vorbereiten von Silizium vor einem Metallierungsschritt, dem Herausarbeiten einer Struktur beziehungsweise bei den letztgenannten Dokumenten der Reinigung dienen.

Der Erfindung liegt die Aufgabe zugrunde, ein Verfahren der eingangs genannten Art anzugeben, das insbesondere auch im industriellen Maßstab verhältnismäßig einfach durchzuführen ist und zu Silizium-Scheiben mit verbessertem Wirkungsgrad führt.

Diese Aufgabe wird bei einem Verfahren der eingangs genannten Art gemäß Anspruch 1 gelöst.

Durch die erfindungsgemäße Zusammensetzung der Ätzlösung anteilig aus 20% bis 55% Wasser, 10% bis 40% Flusssäure mit einer Konzentration von wenigstens 50% und 20% bis 60% Salpetersäure mit einer Konzentration von wenigstens 65% und zusätzlich dem Durchführen des Ätzvorganges bei der verhältnismäßig niedrigen, deutlich unter Raumtemperatur liegenden Ätzbadtemperatur wird eine merkliche Verbesserung des Wirkungsgrades erzielt. Weiterhin gestaltet sich zum einen das Ansetzen der Ätzlösung relativ unkritisch und läßt sich in verhältnismäßig kurzer Zeit durchführen. Zum anderen läßt sich der Ätzvorgang verhältnismäßig einfach kontrollieren.

Bei einer Weiterbildung des erfindungsgemäßen Verfahrens besteht die Ätzlösung anteilig aus 30 % bis 40% Wasser, 15% bis 30% Flusssäure mit einer Konzentration von wenigstens 50% und 30% bis 50% Salpetersäure mit einer Konzentration von wenigstens 65%.

Bei einer weiteren Ausbildung des erfindungsgemäßen Verfahrens liegt die Temperatur der Ätzlösung zwischen 7 Grad Celsius und 9 Grad Celsius.

Zweckmäßigerweise verbleiben bei dem erfindungsgemäßen Verfahren die Silizium-Scheiben zwischen 3 Minuten und 5 Minuten in der Ätzlösung.

Bei einem besonders bevorzugten Ausführungsbeispiel des erfindungsgemäßen Verfahrens besteht die Ätzlösung anteilig aus 31% Wasser, 23% Flusssäure mit einer Konzentration von wenigstens 50% und 46% Salpetersäure mit einer Konzentration von wenigstens 65%, die Temperatur der Ätzlösung liegt bei 8 Grad Celsius und die Silizium-Scheiben verbleiben zwischen 1,5 Minuten und 2 Minuten in der Ätzlösung.

Bei einer Ausgestaltung des erfindungsgemäßen Verfahrens sind die Silizium-Scheiben im wesentlichen vertikal ausgerichtet und die Ätzlösung weist eine Strömungskomponente auf. Dadurch werden beide Oberflächen der Silizium-Scheiben im wesentlichen gleichartig texturiert.

Bei einer weiteren zweckmäßigen Ausgestaltung des erfindungsgemäßen Verfahrens sind die Silizium-Scheiben im wesentlichen horizontal ausgerichtet, wobei die Ätzlösung ruht. Dadurch wird die nach oben weisende Oberfläche durch verhältnismäßig schnell wegperlende Gasbläschen besonders gut texturiert.

Bei einer weiteren, für die kontinuierliche Herstellung von Silizium-Scheiben besonders zweckmäßigen Weiterbildung der letztgenannten Ausgestaltung werden die Silizium-Scheiben durch die Ätzlösung bewegt. Dadurch ergibt sich auf beiden Oberflächenseiten der Silizium-Scheiben besonders gute Texturierungen.

Weitere vorteilhafte Ausgestaltungen der Erfindung sind Gegenstand der nachfolgenden Beschreibung von bevorzugten Ausführungsbeispielen der Erfindung unter Bezug auf die Figuren der Zeichnung. Es zeigen:
- Fig. 1: in einer schematischen Darstellung die Anordnung von Silizium-Scheiben in einer erfindungsgemäßen Ätzlösung gemäß einem ersten Ausführungsbeispiel,
- Fig. 2: in einer schematischen Darstellung die Anordnung von Silizium-Scheiben in einer erfindungsgemäßen Ätzlösung gemäß einem zweiten Ausführungsbeispiel,
- Fig. 3: in einer schematischen Darstellung die Anordnung von Silizium-Scheiben in einer erfindungsgemäßen Ätzlösung gemäß einem dritten Ausführungsbeispiel,
- Fig. 4: in einem Schaubild die qualitative Abhängigkeit der mittleren Reflexion von der Ätzzeit bei einem Ätzvorgang mit einer Ätzlösung bei Raumtemperatur und bei einem Ätzvorgang mit einer erfindungsgemäßen Ätzlösung im erfindungsgemäßen Temperaturbereich,
- Fig. 5: in einem Schaubild die Abhängigkeit der Reflexion von der Wellenlänge bei einer in einer herkömmlichen sauren Ätzlösung texturierten Silizium-Scheibe und einer erfindungsgemäß texturierten Silizium-Scheibe und
- Fig. 6: eine mit einem Elektronenmikroskop gewonnene Darstellung einer Oberfläche einer erfindungsgemäß texturierten Silizium-Scheibe.

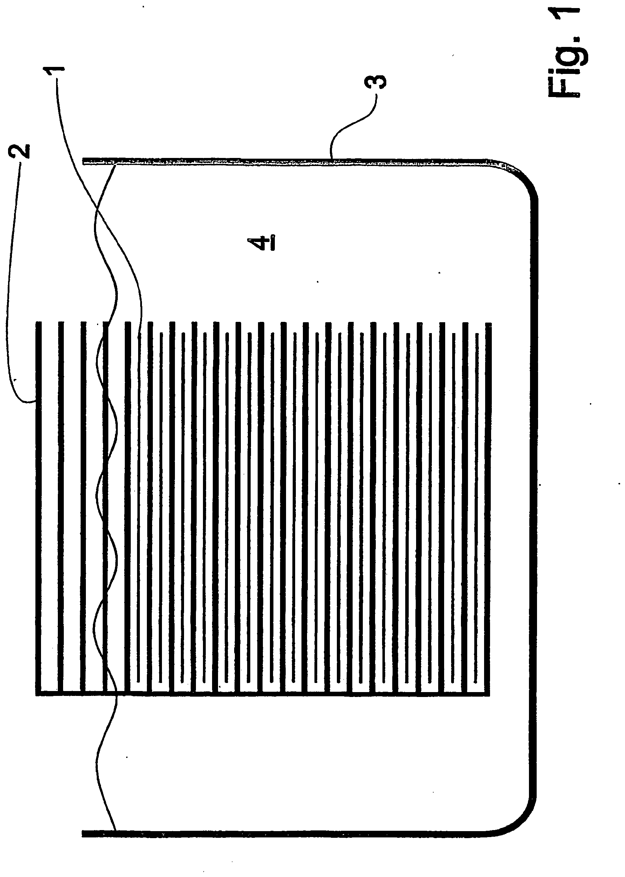

Fig. 1 zeigt in einer schematischen Darstellung eine Anzahl von als sogenannte Wafer ausgebildete multikristalline Silizium-Scheiben 1, die in an sich bekannter Weise mit einem Halter 2 verbunden sind. Der Halter 2 ist in der Darstellung gemäß Fig. 1 mit den Silizium-Scheiben 1 in horizontaler Ausrichtung in eine Wanne 3 eingetaucht die mit einer erfindungsgemäßen ruhenden Ätzlösung 4 gefüllt ist. Diese horizontale Anordnung führt dazu, dass Gasbläschen, die bei der Ätzvorgang an der nach oben weisenden Oberfläche der Silizium-Scheiben 1 entstehen, nach oben wegperlen und dadurch an der nach oben weisenden Oberfläche der Silizium-Scheiben 1 eine für das Verringern von Reflexionen sehr gute Texturierung erfolgt.

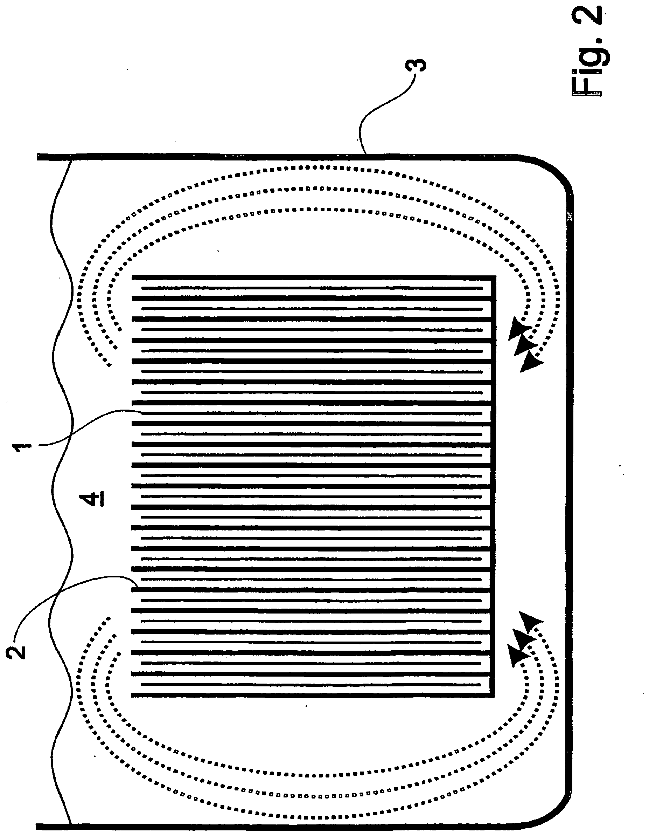

Fig. 2 zeigt in einer schematischen Darstellung die Anordnung von mit einem dem Ausführungsbeispiel gemäß Fig. 1 entsprechenden Halter 2 verbundenen Silizium-Scheiben 1 in einer erfindungsgemäßen Ätzlösung 4 gemäß einem zweiten Ausführungsbeispiel. Gemäß dem zweiten Ausführungsbeispiel sind die Silizium-Scheiben 1 vertikal angeordnet, wobei die Ätzlösung 4 beispielsweise durch Hin- und Herbewegen der Wanne 3 oder durch Einsatz eines in Fig. 2 nicht dargestellten, gegen starke Säuren beständigen Rührwerkzeuges die Ätzlösung 4 entlang der Silizium-Scheiben 1 eine durch gestrichelte Strömungslinien angedeutete Strömungskomponente aufweist. Dadurch wird erreicht, dass sich während des Ätzvorganges an beiden Oberflächen der Silizium-Scheiben 1 ausbildende Gasbläschen frühzeitig ablösen und nach oben wegperlen, so dass beide Oberflächenseiten der Silizium-Scheiben 1 gleichmäßig texturiert werden.

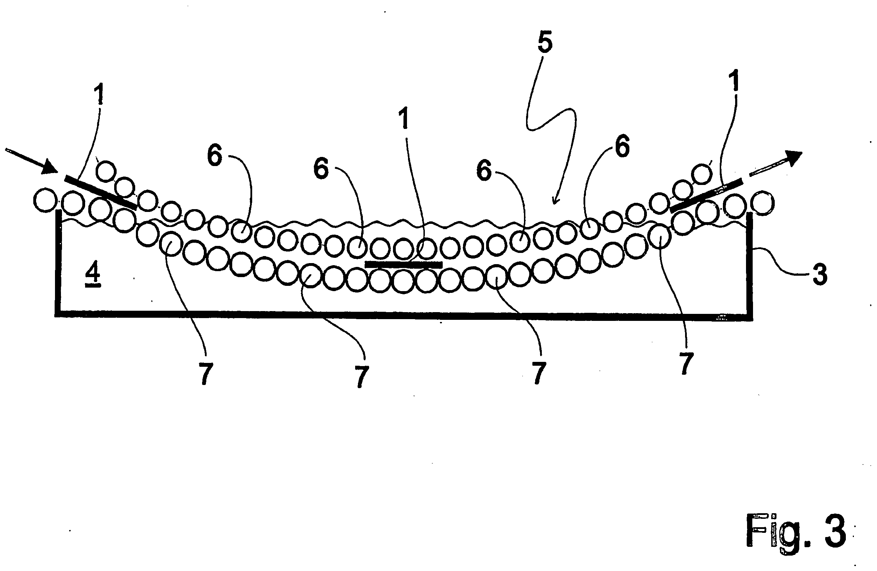

Fig. 3 zeigt in einer schematischen Darstellung die Anordnung von Silizium-Scheiben 1 in einer erfindungsgemäßen Ätzlösung 4 gemäß einem dritten Ausführungsbeispiel. Bei dem Ausführungsbeispiel gemäß Fig. 3 ist eine Rollenbahn 5 mit einer Anzahl von in einem Abstand einander gegenüberliegenden, wenigstens teilweise angetriebenen oberen Rollen 6 und unteren Rollen 7 vorhanden, mit der die zu texturierenden Silizium-Scheiben 1 in einer im wesentlichen horizontalen Bahn durch die in der Wanne 3 vorgehaltene erfindungsgemäße Ätzlösung 4 durchgeführt werden. Dieses Ausführungsbeispiel zeichnet sich dadurch aus, dass es bei sehr gute Texturierung beider Oberflächenseiten für die kontinuierliche Produktion von Silizium-Scheiben 1 besonders gut einsetzbar ist.

Die Zusammensetzung einer beispielhaften erfindungsgemäßen Ätzlösung 4 aus Wasser, konzentrierter Flusssäure, das heißt mit einer Konzentration von wenigstens etwa 50%, und konzentrierter Salpetersäure, das heißt mit einer Konzentration von wenigstens etwa 65%, ist wie folgt, wobei bei anderen Konzentrationen der Flusssäure und der Salpetersäure die Anteile entsprechend anzupassen sind:
- 2: Anteile Wasser (H₂O),
- 1,5: Anteile Flusssäure (HF, Konzentration 50%) und
- 3: Anteile Salpetersäure (HNO₃, Konzentration 65%).

Bei den Ausführungsbeispielen gemäß Fig. 1 bis Fig. 3 wird die Temperatur der Ätzlösung 4 erfindungsgemäß zwischen etwa 0 Grad Celsius und etwa 15 Grad Celsius, bevorzugt zwischen etwa 7 Grad Celsius und etwa 9 Grad Celsius, gehalten.

Damit ergibt sich bei einer unverbrauchten Ätzlösung 4 beim Texturieren eine Verfahrensdauer zu Beginn von etwa 3 Minuten, die sich nach dem Texturieren von 550 Silizium-Scheiben 1 mit einer Größe von 12,5 x 12,5 cm² in etwa 12 Liter Ätzlösung 4 auf etwa 5 Minuten verlängert.

Bei einem besonders bevorzugten Ausführungsbeispiel werden
4 Anteile Wasser (H₂O),
3 Anteile Flusssäure (HF, Konzentration 50%) und
6 Anteile Salpetersäure (HNO₃, Konzentration 65%).
verwendet, wobei die Temperatur der Ätzlösung 4 bei etwa 8 Grad Celsius gehalten wird. Die Verfahrensdauer liegt bei diesem besonders bevorzugten Ausführungsbeispiel zwischen 1,5 Minuten und 2 Minuten.

Der Ätzvorgang wird durch Wiegen texturierter Silizium-Scheiben 1 vor und nach der Ätzvorgang kontrolliert, wobei in Abhängigkeit der Größe der jeweiligen Silizium-Scheibe 1 und des gewünschten Ätzabtrags ein bestimmter Soll-Gewichtsverlust die korrekte Dauer des Ätzvorganges anzeigt. Liegt der Ist-Gewichtsverlust unter dem Soll-Gewichtsverlust, wird die Dauer des Ätzvorganges solange erhöht, bis der Ist-Gewichtsverlust mit dem Soll-Gewichtsverlust übereinstimmt. Liegt entsprechend der Ist-Gewichtsverlust über dem Soll-Gewichtsverlust, wird die Dauer des Ätzvorganges solange verkürzt, bis der Ist-Gewichtsverlust mit dem Soll-Gewichtsverlust übereinstimmt.

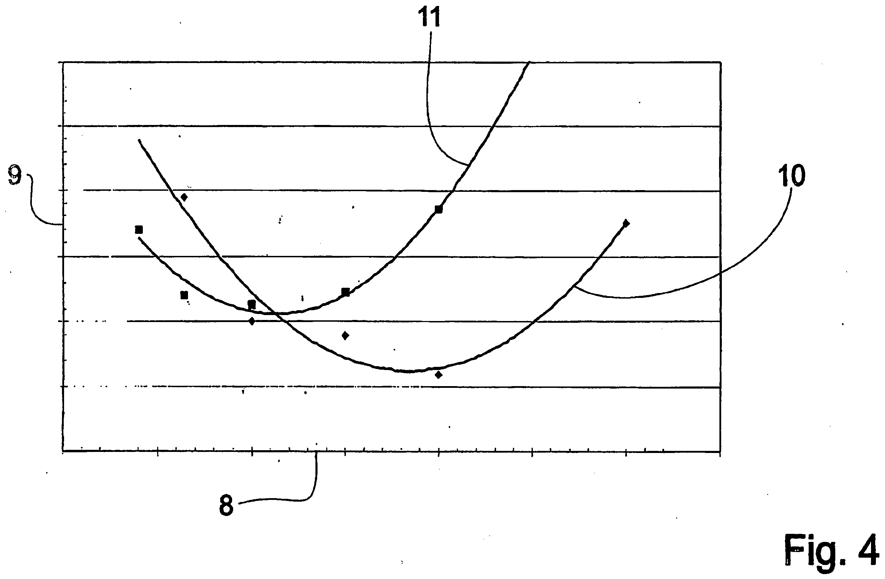

Fig. 4 in einem Schaubild die qualitative Abhängigkeit der mittleren Reflexion von der Ätzzeit bei einem Vergleichsverfahren mit einer Ätzlösung bei Raumtemperatur und bei einem Ätzvorgang mit einer erfindungsgemäßen Ätzlösung im erfindungsgemäßen Temperaturbereich.

In dem Schaubild gemäß ist Fig. 4 auf der Abszisse 8 ist die Ätzzeit abgetragen. Auf der Ordinaten 9 ist die über einen Wellenlängenbereich von 400 Nanometer bis 1100 Nanometer gemittelte mittlere Reflexion abgetragen. Die durch eine erste Näherungskurve 10 approximierten Werte stammen von mit dem erfindungsgemäßen Verfahren texturierten Silizium-Scheiben 1. Die durch eine zweite Näherungskurve 11 approximierten Messwerte stammen von mit einem Vergleichsverfahren texturierten Silizium-Scheiben.

Der Vergleich der ersten Näherungskurve 10 für das Verfahren gemäß der Erfindung mit der zweiten Näherungskurve für das Vergleichsverfahren zeigt, dass die mittlere Reflexion bei erfindungsgemäß texturierten Silizium-Scheiben 1 merklich niedriger ist als bei den mit dem Vergleichsverfahren texturierten Silizium-Scheiben.

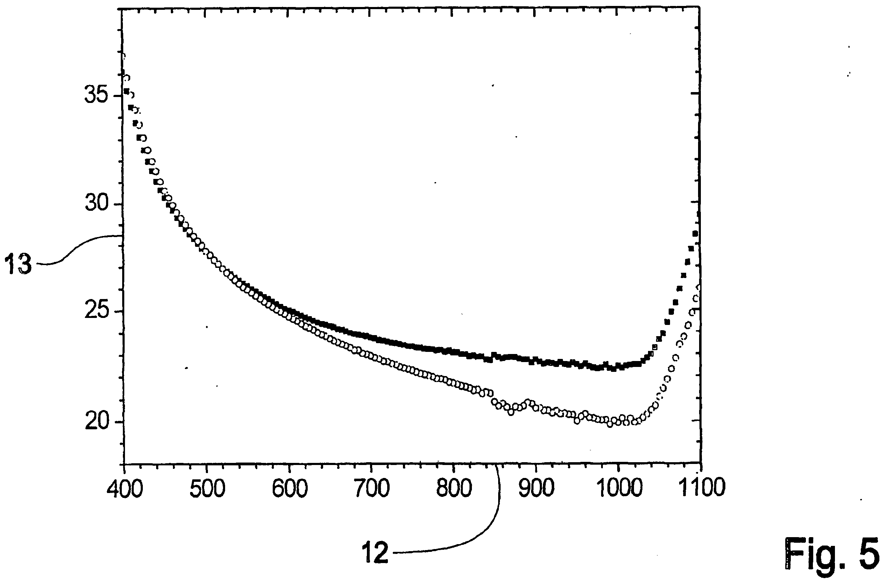

Fig. 5 zeigt in einem Schaubild die Abhängigkeit der Reflexion von der Wellenlänge bei einer in einer herkömmliche sauren Ätzlösung texturierten Silizium-Scheibe und einer erfindungsgemäß texturierten Silizium-Scheibe 1.

In dem Schaubild gemäß Fig. 5 ist auf der Abszissen 12 die Wellenlänge in Nanometer und auf der Ordinaten 13 die Reflexion in Prozent abgetragen. Die nicht ausgefüllten Kreise stehen für Messwerte bei mit dem erfindungsgemäßen Verfahren mit der oben angegebenen beispielhaften Ätzlösung 4 texturierten Silizium-Scheiben 1, während die mit ausgefüllten Quadraten repräsentierten Messwerte für ein herkömmliches, von IMEC entwickelten Verfahren (nachfolgend "IMEC-Vergleichsverfahren" genannt) nach dem Artikel "Torwards Highly Efficient Industrial Cells and Modules from Multicrystalline Wafers" von F. Duerinckx, L. Frisson, P.P. Michiels et al., erschienen bei 17th European Photovoltaic Solar Energy Conference, 22. bis 26. Oktober 2001, München, Deutschland, stehen.

Bei dem IMEC-Vergleichsverfahren weist die Ätzlösung HF, HNO₃ sowie einige Additive auf. Die Temperatur der Ätzlösung beträgt 21 Grad Celsius. Die Silizium-Scheiben verbleiben 3 Minuten in der Ätzlösung.

Dem Schaubild gemäß Fig. 5 ist zu entnehmen, dass sich bei erfindungsgemäß texturierten Silizium-Scheiben 1 mit einer mittleren Reflexion von 23,8% insbesondere ab einer Wellenlänge von etwa 600 Nanometer um bis zu etwa 2,5% niedrigere Reflexionswerte als bei gemäß dem IMEC-Vergleichsverfahren texturierten Silizium-Scheiben mit einer mittleren Reflexion von 24,9% ergeben.

In der nachfolgenden Tabelle sind wichtige Kenngrößen für erfindungsgemäß texturierten Silizium-Scheiben 1 (UKN-Isotextur) und gemäß dem IMEC-Vergleichsverfahren texturierten Silizium-Scheiben (IMEC-Isotextur) jeweils im Vergleich mit einer Texturieren mit einer basischen NaOH-Lösung gegenübergestellt.

| | UKN-Isotextur | | | | IMEC-Isotextur | | | |
|---|---|---|---|---|---|---|---|---|
| | FF % | J_{SC} mA/cm² | V_{OC} mV | Eta % | FF % | J_{SC} mA/cm² | V_{OC} mV | Eta % |
| NaOH | 76,3 | 31,2 | 615,9 | 14,6 | 77,9 | 30,5 | 620 | 14,8 |
| Isotextur | 76,6 | 33,2 | 614,1 | 15,6 | 77,9 | 31,6 | 614 | 15,2 |
| Verbesserung relativ [%] | 0,4 | 5,4 | -0,3 | 6,8 | 0 | 3,6 | -1 | 2,7 |

Für die IMEC-Isotextur sind die Daten aus Duerinckx et al. abgeleitet.

Dabei bedeuten für die jeweiligen Silizium-Scheiben:
- FF:: Füllfaktor,
- J_{SC}:: Kurzschlussstromdichte,
- V_{OC}:: offene Klemmenspannung und
- Eta:: Wirkungsgrad.

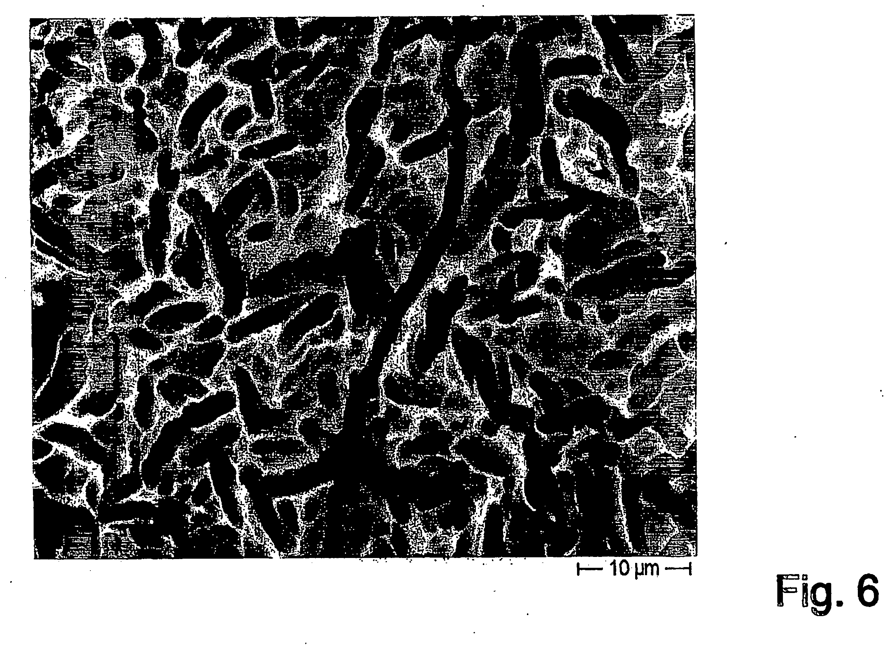

Fig. 6 zeigt eine vergrößerte fotografische Darstellung einer Oberfläche einer erfindungsgemäß texturierten Silizium-Scheibe 1 mit einer Skalierungsangabe. Aus Fig. 6 ist ersichtlich, dass die Texturierung gemäß dem erfindungsgemäßen Verfahren zu zum Teil verhältnismäßig langgestreckten bandartigen Vertiefungen führt, in eine ausgeprägte reflexionsmindernde Strukturierung der Oberfläche hervorrufen.

## Patentansprüche

1. Verfahren zum Texturieren zur reflexionsmindernden Strukturierung von Oberflächen von Silizium-Scheiben mit den Schritten des Eintauchens der Silizium-Scheiben (1), wobei die Silizium-Scheiben (1) multikristallin sind, in einer Ätzlösung aus Wasser, Flusssäure mit einer Konzentration von wenigstens 50% und Salpetersäure mit einer Konzentration von wenigstens 65% und des Einstellens einer Temperatur für die Ätzlösung, **dadurch gekennzeichnet, dass** die Ätzlösung (4) nur aus 20% bis 55% Wasser, 10% bis 40% Flusssäure mit einer Konzentration von wenigstens 50% und 20% bis 60% Salpetersäure mit einer Konzentration von wenigstens 65% besteht und dass die Temperatur der Ätzlösung (4) zwischen 0 Grad Celsius und 15 Grad Celsius liegt.

2. Verfahren nach Anspruch 1, **dadurch gekennzeichnet, dass** die Ätzlösung (4) anteilig aus 30% bis 40% Wasser, 15% bis 30% Flusssäure mit einer Konzentration von wenigstens 50% und 30% bis 50% Salpetersäure mit einer Konzentration von wenigstens 65% besteht.

3. Verfahren nach Anspruch 1 oder Anspruch 2, **dadurch gekennzeichnet, dass** die Temperatur der Ätzlösung (4) zwischen 7 Grad Celsius und 9 Grad Celsius liegt.

4. Verfahren nach einem der Ansprüche 1 bis 3, **dadurch gekennzeichnet, dass** die Silizium-Scheiben (1) zwischen 3 Minuten und 5 Minuten in der Ätzlösung (4) verbleiben.

5. Verfahren nach Anspruch 1, **dadurch gekennzeichnet, dass** die Ätzlösung (4) anteilig aus 31% Wasser, 23% Flusssäure mit einer Konzentration von wenigstens 50% und 46% Salpetersäure mit einer Konzentration von wenigstens 65% besteht, dass die Temperatur der Ätzlösung (4) bei 8 Grad Celsius liegt und dass die Silizium-Scheiben (1) zwischen 1,5 Minuten und 2 Minuten in der Ätzlösung (4) verbleiben.

6. Verfahren nach einem der Ansprüche 1 bis 5, **dadurch gekennzeichnet, dass** die Silizium-Scheiben (1) im wesentlichen vertikal ausgerichtet sind und dass die Ätzlösung (4) eine Strömungskomponente aufweist.

7. Verfahren nach einem der Ansprüche 1 bis 5, **dadurch gekennzeichnet, dass** die Silizium-Scheiben (1) im wesentlichen horizontal ausgerichtet sind und dass die Ätzlösung (4) ruht.

8. Verfahren nach Anspruch 7, **dadurch gekennzeichnet, dass** die Silizium-Scheiben (1) durch die Ätzlösung (4) bewegt werden.

## Claims

1. Method for texturing for reflection decreasing structuring of surfaces of silicon wafers, comprising the steps of immersing the silicon wafer (1) wherein the silicon wafers (1) are multicrystalline in an etching solution of water, hydrofluoric acid with a concentration of at least 50% and nitric acid with a concentration of at least 65% and setting a temperature for the etching solution, **characterised in that** the etching solution (4) comprises only 20% to 55% water, 10% to 40% hydrofluoric acid with a concentration of at least 50% and 20% to 60% nitric acid with a concentration of at least 65% and that the temperature of the etching solution (4) is in the range of 0°C to 15°C.

2. Method according to claim 1, **characterised in that** the etching solution (4) comprises 30% to 40% water, 15% to 30% hydrofluoric acid with a concentration of at least 50% and 30% to 50% nitric acid with a concentration of at least 65%.

3. Method according to claim 1 or claim 2, **characterised in that** the temperature of the etching solution (4) lies in the range of 7°C to 9°C.

4. Method according to one of the claims 1 to 3, **characterised in that** the silicon wafers (1) remain in the etching solution (4) for a time in the range of 3 minutes to 5 minutes.

5. Method according to claim 1, **characterised in that** the etching solution (4) comprises 31% water, 23% hydrofluoric acid with a concentration of at least 50% and 46% nitric acid with a concentration of at least 65%, that the temperature of the etching solution (4) is 8°C and that the silicon wafers (1) remain in the etching solution (4) for a time in the range of 1.5 minutes to 2 minutes.

6. Method according to one of the claims 1 to 5, **characterised in that** the silicon wafers (1) are substantially vertically oriented and that the etching solution (4) has a flow component.

7. Method according to one of the claims 1 to 5, **characterised in that** the silicon wafers (1) are substantially horizontally oriented and that the etching solution (4) is at rest.

8. Method according to claim 7, **characterised in that** the silicon wafers (1) are moved through the etching solution (4).

## Revendications

1. Procédé de texturation pour la structuration diminuant la réflexion des surfaces de tranches de silicium, comportant les étapes de l'immersion des tranches de silicium (1) cependant les tranches de silicium (1) sont multicristallines dans une solution d'attaque composée d'eau, d'acide fluorhydrique dans une concentration d'au moins 50 % et d'acide nitrique dans une concentration d'au moins 65 %, et de l'établissement d'une température pour la solution d'attaque, **caractérisé en ce que** la solution d'attaque (4) n'est composée que de 20 % à 55 % d'eau, de 10 % à 40 % d'acide fluorhydrique dans une concentration d'au moins 50 %, et de 20 % à 60 % d'acide nitrique dans une concentration d'au moins 65 %, et **en ce que** la température de la solution d'attaque (4) se situe entre 0 degré Celsius et 15 degrés Celsius.

2. Procédé selon la revendication 1, **caractérisé en ce que** la solution d'attaque (4) est composée proportionnellement de 30 % à 40 % d'eau, 15 % à 30 % d'acide fluorhydrique dans une concentration d'au moins 50 % et de 30 % à 50 % d'acide nitrique dans une concentration d'au moins 65 %.

3. Procédé selon la revendication 1 ou la revendication 2, **caractérisé en ce que** la température de la solution d'attaque (4) se situe entre 7 degrés Celsius et 9 degrés Celsius.

4. Procédé selon une des revendications 1 à 3, **caractérisé en ce que** les tranches de silicium (1) restent dans la solution d'attaque (4) pendant une durée comprise entre 3 minutes et 5 minutes.

5. Procédé selon la revendication 1, **caractérisé en ce que** la solution d'attaque (4) est composée proportionnellement de 31 % d'eau, 23 % d'acide fluorhydrique dans un concentration d'au moins 50 % et de 46 % d'acide nitrique dans une concentration d'au moins 65 %, **en ce que** la température de la solution d'attaque (4) se situe à 8 degrés Celsius, et **en ce que** les tranches de silicium (1) restent dans la solution d'attaque (4) pendant une durée comprise entre 1,5 minute et 2 minutes.

6. Procédé selon une des revendications 1 à 5, **caractérisé en ce que** les tranches de silicium (1) sont orientées sensiblement verticalement, et **en ce que** la solution d'attaque (4) présente une composante d'écoulement.

7. Procédé selon une des revendications 1 à 5, **caractérisé en ce que** les tranches de silicium (1) sont orientées sensiblement horizontalement, et **en ce que** la solution d'attaque (4) est statique.

8. Procédé selon la revendication 7, **caractérisé en ce que** les tranches de silicium (1) sont mises en mouvement par la solution d'attaque (4).
